# FASCICULE DE BREVET EUROPEEN

(11) **EP 2 783 022 B1**
(45) Date de publication et mention de la délivrance du brevet: **30.05.2018**
(21) Numéro de dépôt: 12794227.4
(22) Date de dépôt: 19.11.2012
(51) Int. Cl.: C23C 14/06, C23C 14/02, C23C 14/00, A47J 36/02

(54) **SURFACE DE CUISSON RESISTANTE AU TACHAGE ET ARTICLE CULINAIRE OU APPAREIL ELECTROMENAGER COMPORTANT UNE TELLE SURFACE DE CUISSON**
FLECKENBESTÄNDIGE KOCHFLÄCHE UND KOCHARTIKEL ODER ELEKTRISCHES HAUSHALTSGERÄT MIT EINER SOLCHEN KOCHFLÄCHE
STAIN-RESISTANT COOKING SURFACE AND COOKWARE ITEM OR ELECTRICAL HOUSEHOLD APPLIANCE COMPRISING SUCH A COOKING SURFACE

(30) Priorité: 21.11.2011 FR 1160583
(43) Date de publication de la demande: 01.10.2014
(73) Titulaire: SEB S.A., 69130 Ecully (FR); Université de Lorraine, 54052 Nancy Cedex (FR); Centre National de la Recherche Scientifique, 75794 Paris Cedex 16 (FR)
(72) Inventeur: PIGEAT, Philippe, F-54000 Nancy (FR); PIERSON, Jean-François, F-88450 Vincey (FR); MEGE-REVIL, Alexandre, F-59651 Villeneuve d'Ascq Cedex (FR); TESSIER, Frédéric, F-60026 Beauvais (FR); ALLEMAND, Simon, F-74150 Rumilly (FR); TUFFE, Stéphane, F-73160 Cognin (FR)
(74) Mandataire: Cémeli, Eric Philippe Laurent
(86) Numéro de dépôt international: PCT/EP2012/073007
(87) Numéro de publication internationale: WO 2013/076046

(56) Documents cités:
- WO-A1-2004/084690
- WO-A1-2005/111256
- WO-A1-2010/117649
- FR-A1- 2 956 310

## Description

La présente invention concerne le domaine des articles culinaires et des appareils électroménagers destinés à la cuisson des aliments, et plus particulièrement la surface de cuisson de ces articles culinaires ou appareils électroménagers en contact avec les aliments à traiter.

La présente invention vise à l'amélioration des surfaces de cuisson dures, susceptibles d'être nettoyées à l'aide d'un tampon abrasif, sans conduire à la formation de rayures.

Les aciers inoxydables sont couramment utilisés pour la réalisation de surfaces de cuisson. Toutefois les aciers inoxydables présentent une dureté insuffisante pour résister à un nettoyage avec un tampon abrasif. De plus ces matériaux présentent des phénomènes de tachage lors de la cuisson, ainsi que des phénomènes d'accrochage des aliments lors de la cuisson.

Les demandes de brevet FR 2 848 797, FR 2 883 150 et FR 2 897 250 divulguent des surfaces de cuisson plus dures que l'acier inoxydable. Ces surfaces présentent notamment la propriété d'être relativement faciles à nettoyer après leur utilisation en tant que surface de cuisson d'aliments, cette facilité de nettoyage pouvant être exprimée par la possibilité d'enlever facilement des éléments carbonisés sur la surface de cuisson. Des phénomènes de tachage ont toutefois été observés sur de telles surfaces de cuisson au contact de certains aliments. Ces phénomènes de tachage ont lieu sur des dépôts présentant des structures et des compositions variées, sans que la préparation de surface effectuée avant lesdits dépôts ne modifie l'apparition et/ou l'ampleur de ces taches. Des analyses de ce phénomène montrent notamment que de telles taches se forment essentiellement lors de cuisson avec des graisses animales, par réaction des graisses avec la surface et/ou par oxydation de la surface.

La demande de brevet FR 2 956 310 divulgue une surface de cuisson d'aliments pour article culinaire ou appareil électroménager de cuisson, consistant en un dépôt de Zr et/ou Nb et/ou Ti sur un substrat, l'élaboration comportant une étape de carburation et/ou de nitruration d'au moins l'un des éléments, cette surface de cuisson comportant également un dépôt de Si afin de réaliser des revêtements (Zr/Nb/Ti)-Si-(N/C). Il a été observé que la présence de Si dans les dépôts de métaux de transition précités permet d'améliorer un peu la résistance au tâchage de la surface de cuisson ainsi obtenue. Toutefois une telle composition ne permet pas de lutter efficacement contre les phénomènes d'oxydation générant le tachage de la surface de cuisson, notamment lors de la réalisation de cuissons à température élevée. De plus ces revêtements restent sujets à des phénomènes d'adhésion lors de la cuisson de certains aliments, tels que notamment les pommes de terre ou des poissons. De ce fait, le nettoyage de ces surfaces de cuisson reste insatisfaisant.

Une surface de cuisson d'aliments pour article culinaire ou appareil électroménager de cuisson selon le préambule de la revendication 1 est connue du document WO 2010/117649.

L'objet de la présente invention est de proposer une surface de cuisson présentant une bonne résistance à la rayure, qui présente aussi une bonne résistance au tachage.

Un autre objet additionnel de la présente invention est de proposer une surface de cuisson qui présente une bonne facilité de nettoyage, qui soit pérenne dans le temps.

Un objet additionnel de la présente invention est de proposer une surface de cuisson sur laquelle l'adhésion des aliments lors de la cuisson est peu importante.

Un autre objet additionnel de la présente invention est de proposer une surface de cuisson dont la couleur et l'aspect restent stables.

Ces objets sont atteints avec une surface de cuisson d'aliments pour article culinaire ou appareil électroménager de cuisson, consistant en un dépôt de nitrure d'éléments métalliques sur un substrat, les éléments métalliques du dépôt comprenant un ou plusieurs métaux de transition X et l'aluminium, l'élaboration dudit dépôt comportant une étape de nitruration pour obtenir un revêtement de type (X,Al)N, du fait que le revêtement de type (X,Al)N est un revêtement de nitrure(s) du ou des métaux de transition X enrichi(s) en aluminium dans lequel le niobium et/ou le zirconium est/sont majoritaire(s) parmi le ou les métaux de transition X, et que la proportion atomique d'aluminium dans les éléments métalliques dudit dépôt est au moins égale à 20%.

Par l'expression « revêtement de type (X,Al)N», on entend un revêtement nitruré comportant le ou les métaux de transition X et de l'aluminium, une étape de nitruration ayant lieu pendant ou après le dépôt des éléments métalliques mentionnés. Ainsi la couche superficielle du dépôt formant la surface de cuisson est un nitrure du ou des métaux de transition X enrichi en aluminium. Par l'expression « nitrure du ou des métaux de transition X enrichi en aluminium », on entend un revêtement présentant une structure cristallographique du type de celle d'un nitrure de métal de transition ou d'un nitrure de métaux de transition, et non du type de celle du nitrure d'aluminium hexagonal. Par l'expression « le revêtement de type (X,Al)N est un revêtement de nitrure(s) du ou des métaux de transition X enrichi(s) en aluminium dans lequel le niobium et/ou le zirconium est/sont majoritaire(s) parmi le ou les métaux de transition X », on entend, dans le cas de plusieurs métaux de transition, un revêtement comportant un seul nitrure, par exemple un nitrure mixte de Zr et Nb, enrichi en aluminium, ou plusieurs nitrures, par exemple un nitrure de Zr ou de Nb, majoritaire, et un nitrure de Ti ou de Cr, minoritaire, ces nitrures étant enrichis en aluminium.

Les dépôts de nitrure d'aluminium résistent bien au tachage et sont faciles à nettoyer, toutefois ces dépôts présentent une dureté insuffisante pour résister de manière satisfaisante à la rayure. De plus ces dépôts ne résistent pas aux lavages effectués en lave-vaisselle.

L'ajout d'aluminium dans les proportions précitées pour obtenir un revêtement de type (X,Al)N permet d'améliorer de façon importante les propriétés de résistance à l'oxydation et par conséquent la résistance au tachage du revêtement, tout en conservant une dureté élevée. De même, il a été mesuré que cela contribue également à obtenir une moindre adhésion des aliments en cours de cuisson.

Le ou les métaux de transition X ne sont pas nécessairement majoritaires par rapport à l'aluminium.

Selon une forme préférée de réalisation, le ou les métaux de transition X est/sont choisi(s) parmi Nb et/ou Zr. Le niobium et le zirconium permettent en effet d'obtenir des nitrures NbN, ZrN ou (Zr,Nb)N qui présentent des propriétés de facilité de nettoyage.

Ainsi, la présente invention se propose d'améliorer l'inertie chimique des couches connues à base de métal ou de métaux de transition tel que Nb et/ou Zr sous forme de nitrures, en tant que surface de cuisson, par adjonction d'aluminium au cours de l'élaboration.

Les dépôts de nitrures de métal ou de métaux de transition tels que Nb et/ou Zr présentent une dureté satisfaisante et une bonne résistance aux passages en lave-vaisselle, toutefois leur résistance au tachage est insuffisante. De plus ces dépôts sont sujets à une forte adhésion de certains aliments lors de la cuisson et sont difficiles à nettoyer.

Différentes études et analyses ont montré que les dépôts de nitrure mixte de métal ou de métaux de transition tel que Nb et/ou Zr et d'aluminium dans les proportions précitées permettent de diminuer notablement la sensibilité au tachage. Ces dépôts sont également compatibles avec des passages au lave-vaisselle.

Par ailleurs, différents essais ont montré que l'ajout d'aluminium dans les proportions précitées permet de conserver une dureté suffisante, favorisant la résistance aux rayures.

Avantageusement, la proportion atomique d'aluminium dans les éléments métalliques dudit dépôt est comprise entre 20% et 75%. Les revêtements de type (X,Al)N présentant ces caractéristiques présentent des propriétés de résistance à la rayure et de résistance au tachage satisfaisantes.

Avantageusement encore, la proportion atomique d'aluminium dans les éléments métalliques dudit dépôt est comprise entre 40% et 75%. Une proportion importante d'aluminium parmi les éléments métalliques des dépôts permet de plus de diminuer l'adhésion des aliments, et d'améliorer la facilité de nettoyage.

De manière surprenante, l'ajout d'une proportion importante d'aluminium, non seulement n'a pas dégradé l'aptitude de ces couches à être facilement nettoyées après leur utilisation en tant que surface de cuisson, mais a même renforcé cette propriété, améliorant ainsi considérablement les différentes qualités de ces couches, au-delà du but initialement recherché.

Avantageusement encore, la proportion atomique d'aluminium dans les éléments métalliques dudit dépôt est comprise entre 40% et 60%. Ces proportions d'aluminium parmi les éléments métalliques des dépôts permettent de limiter notablement l'adhésion des aliments sur la surface de cuisson et d'améliorer notoirement la facilité de nettoyage. On observe égalemet qu'au-delà d'une proportion atomique d'aluminium supérieure à 60%, la résistance aux passages en lave-vaisselle commence à diminuer en raison de la teneur trop importante en aluminium.

Selon un mode préféré d'élaboration, le dépôt est réalisé par dépôt physique en phase vapeur, usuellement dénommé PVD. Le dépôt physique en phase vapeur est un procédé connu de dépôt de matériaux, présentant l'avantage d'utiliser peu de matière et de pouvoir ajuster une faible épaisseur de matériau sur le substrat en vue de réaliser la surface de cuisson, diminuant ainsi le coût en matière première de ces matériaux. Cette technique de dépôt permet, par ailleurs, d'obtenir des dépôts de forte adhésion avec le substrat sur lequel ils sont déposés. Les risques de décollement du dépôt au cours de l'utilisation sont ainsi minimisés. Cet aspect est d'importance puisque la surface de cuisson doit résister aux sollicitations mécaniques engendrées par l'utilisation de fourchettes, couteaux et autres accessoires de cuisine lors de la manipulation des aliments dans un ustensile de cuisson tel qu'un article culinaire ou un appareil électroménager de cuisson comportant ladite surface de cuisson.

Lorsque la technique de dépôt physique en phase vapeur est utilisée, la pulvérisation par processus physique est obtenue par l'application d'une différence de potentiel entre des parois incluant au moins un substrat sur lequel le dépôt sera réalisé et une ou plusieurs cibles. Avantageusement le dépôt est réalisé à partir d'une ou plusieurs cibles obtenues par assemblage sur un support conducteur d'une ou plusieurs tôle(s) ou plaque(s) de matériau ayant la composition recherchée, lesdites tôles ou plaques étant obtenues soit par laminage, soit par frittage de poudre ou projection thermique de poudre, soit issues de coulée. D'une manière générale, toutes les techniques de dépôt physique en phase vapeur peuvent être utilisées, comme par exemple l'évaporation par arc cathodique en conditions réactives.

Avantageusement, le dépôt est réalisé en condition réactive, c'est-à-dire en présence de gaz réactif tel que l'azote, afin d'accomplir, pendant l'étape de dépôt, l'étape de nitruration, permettant de réduire le temps de traitement, tout en augmentant la dureté des revêtements.

En alternative, des dépôts réalisés par technique de dépôts chimique en phase vapeur, usuellement dénommés dépôts type CVD, peuvent être également envisagés. Toutefois, seuls les dépôts type CVD assisté par plasma peuvent être envisagés pour produire le revêtement visé, les dépôts étant alors réalisés à basse température et basse pression. Le substrat est exposé à des précurseurs en phase gazeuse qui réagissent et se décomposent à la surface du substrat pour générer le dépôt désiré. Le plasma permet d'augmenter le taux de réaction des précurseurs et permet le dépôt à plus faible température, typiquement entre 200 et 500°C.

Afin d'optimiser les durées de traitement et le coût de ce revêtement, l'épaisseur du dépôt de nitrure (X,Al)N réalisé est comprise entre 3 et 10 µm , et de préférence entre 4 et 6 µm. Une épaisseur minimale de 3 à 4 µm est en effet nécessaire pour d'obtenir un revêtement résistant totalement à la rayure avec un tampon abrasif de type Scotch Brite® vert chargé avec des particules d'alumine.

Selon un procédé préféré de réalisation, une couche de dépôt métallique de l'un ou plusieurs des constituants est réalisée avant la phase de nitruration, afin de renforcer l'adhésion entre le revêtement et le substrat. De plus, le dépôt d'une couche métallique est plus rapide que le dépôt de cette même couche avec un gaz réactif, ce qui permet une plus grande vitesse de dépôt au global. Si désiré, une couche d'accrochage d'oxynitrure déposée sur le substrat peut notamment être utilisée.

Le substrat peut être composé d'une ou plusieurs tôle(s) métallique(s) des matériaux suivants : aluminium, cuivre, fonte, acier, notamment acier inoxydable. Le substrat peut notamment être formé par un matériau sandwich colaminé, tel que par exemple acier inoxydable/aluminium/acier inoxydable.

La présente invention vise également un article culinaire destiné à la cuisson d'aliments, comportant une surface de cuisson telle que précédemment décrite. Un tel article culinaire peut être notamment une poêle, une casserole, un faitout, un wok,...

La présente invention porte également sur un appareil électroménager destiné à la cuisson d'aliments, comportant une surface de cuisson et des moyens de chauffe électrique ou à gaz de ladite surface de cuisson, ladite surface de cuisson étant conforme à l'une des caractéristiques précédemment décrites. Un tel appareil électroménager peut être notamment un appareil de préparation culinaire chauffant, un appareil à raclette, un appareil à fondue, une friteuse, une machine à pain, un cuiseur à riz...

L'invention sera mieux comprise à l'étude de deux exemples de réalisation, pris à titre nullement limitatif, dont une forme de réalisation et des propriétés sont illustrées dans les figures annexées, dans lesquelles :
- la figure 1 est une vue en coupe d'une forme de réalisation d'une surface de cuisson selon l'invention, dans laquelle une couche d'accroché 2 est intercalée entre un substrat 1 et une couche de nitrure 3.
- la figure 2 représente des mesures de nanodureté (exprimées en GPa) effectuées sur des revêtements (Nb,Al)N, en fonction du pourcentage atomique d'aluminium (de 0 à 65% d'Al).

Le premier exemple de mise en oeuvre de la présente invention concerne le dépôt de revêtement (Nb,Al)N sur un substrat.

Le substrat peut avantageusement être composé d'une ou plusieurs tôle(s) métallique(s) des matériaux suivants : aluminium, cuivre, fonte, acier, notamment acier inoxydable. Le substrat utilisé est de préférence un acier inoxydable austénitique (par exemple un acier inoxydable de type 304), après dégraissage et décapage ionique du substrat. Plus généralement, l'article culinaire est composé d'un matériau sandwich comportant trois feuilles colaminées, avec une feuille d'aluminium intercalée entre deux feuilles d'acier inoxydable, pour obtenir un matériau « triply » acier inoxydable/aluminium/acier inoxydable.

Plusieurs compositions ont été testées avec des pourcentages atomiques d'aluminium de 2% ; 13% ; 22% ; 53% ; 59% et 75%, ainsi que des dépots de NbN et d'AlN effectués dans des conditions similaires, pour comparaison des propriétés obtenues.

Les dépôts sont élaborés par dépôt physique en phase vapeur, usuellement dénommé technique PVD (pour « Physical Vapor Déposition »), plus particulièrement en pulvérisation cathodique magnétron réactive. La pulvérisation cathodique magnétron permet d'obtenir des dépôts denses, adhérents au substrat ainsi qu'une vitesse de dépôt relativement rapide. D'autres techniques de dépôts PVD peuvent toutefois être envisagées (arc cathodique).

De manière usuelle, le dépôt est réalisé à partir d'une ou plusieurs cibles obtenues par assemblage sur un support conducteur d'une ou plusieurs tôle(s) ou plaque(s) de matériau ayant la composition recherchée, lesdites tôles ou plaques étant obtenues soit par laminage, soit par frittage de poudre ou projection thermique de poudre, soit issues de coulée.

La méthode d'élaboration est ainsi un dépôt en phase vapeur réactive où, après un vide poussé de l'enceinte, ne subsiste essentiellement que de l'argon nécessaire à la réalisation du plasma, la pulvérisation de la cible métallique est réalisée en introduisant de l'azote dans le plasma d'argon afin que la pulvérisation de la cible métallique ou des cibles métalliques permette l'obtention de nitrure de niobium enrichi en aluminium (Nb,Al)N. Le dépôt (Nb,Al)N peut être obtenu soit à partir de la pulvérisation d'une cible composite Nb-Al, soit à partir de 2 cibles distinctes de Nb et d'Al. Le dépôt réalisé en condition réactive permet d'accomplir l'étape de nitruration pendant l'étape de dépôt.

Différents paramètres d'élaboration peuvent être modifiés afin de faire varier la vitesse de dépôt (épaisseur du revêtement) et la qualité du dépôt, dans le but d'obtenir des couches suffisamment épaisses pour pouvoir être caractérisées, mais sans excès afin de conserver une bonne adhérence avec le substrat.

Le choix s'est porté sur l'utilisation d'un magnétron pour augmenter les vitesses de dépôt tout en permettant l'obtention de revêtements denses et purs par diminution de la pression dans l'enceinte.

Par ailleurs, l'influence du débit d'azote, notamment sur la vitesse de dépôt et la structure cristalline du revêtement a permis de trouver une plage de débit optimale pour l'obtention d'une vitesse de dépôt de l'ordre de 1,5 µm/h à 4 µm/h. Il a par ailleurs été remarqué que l'ajout d'aluminium tend à diminuer la vitesse de dépôt, dans le cas de l'utilisation d'une cible en alliage NbAI.

L'une des caractéristiques des couches est la mesure de leurs épaisseurs, à l'aide d'un profilomètre qui permet de retranscrire sur papier, après amplification, les mouvements d'un stylet se déplaçant sur la surface du revêtement, un décrochement brusque signifiant que le stylet est en contact avec le substrat. La mesure de ce décrochement, après calibration ou utilisation d'abaques, permet de mesurer l'épaisseur du revêtement. Des résultats similaires peuvent être obtenus en utilisant un profilomètre non tactile. Cette mesure est complétée par une analyse en section transverse par microscopie électronique à balayage. Enfin, la mesure d'épaisseur du revêtement peut être pratiquée par toutes autres méthodes permettant de mesurer précisément l'épaisseur de revêtements micrométriques comme par exemple la méthode du « Calotest » ® ou par observation par microscopie optique ou électonique (MEB) d'une coupe (notamment d'une section transverse) ou d'une fracture du revêtement.

Une autre mesure concerne l'analyse chimique du revêtement, obtenue soit par microsonde de Castaing, soit par spectrométrie à dispersion d'énergie de photons X couplée à un microscope électronique à balayage, où l'on observe la désexcitation des électrons d'atomes du revêtement après le bombardement électronique, indiquant ainsi la nature de l'élément ayant émis l'électron excité, soit par diffraction des rayons X en configuration Bragg-Brentanno, permettant d'identifier les différentes phases cristallines de la couche.

Pour faire varier plus facilement le pourcentage d'aluminium présent dans le dépôt (Nb,Al)N des cibles distinctes de Nb et d'Al sont de préférence utilisées. Différents dépôts ont été réalisés en conservant les paramètres optimisés pour le dépôt de NbN tel que précédemment évoqué. Cette teneur en Al des différents revêtements peut être mesurée par analyse EDS.

En supposant que le composé NbN est stoechiométrique, le rapport Al/Nb permet de remonter à la concentration atomique en Al, après détermination des éléments en présence.

Le substrat est avantageusement constitué de trois couches successives d'acier inoxydable ferritique, d'aluminium et d'acier inoxydable austénitique, toutes ces couches présentant une épaisseur de 0,4 mm. Avant le dépôt du revêtement choisi, une couche de NbAl ou une couche d'oxyde est effectuée sur une épaisseur maximale de 1 µm, afin d'assurer une bonne adhérence entre l'inox austénitique du substrat et le revêtement.

Le revêtement est ensuite déposé sur une épaisseur suffisante (environ 3 µm) avant de subir la cuisson et le test de facilité de nettoyage réalisé par un plynomètre. De manière avantageuse l'épaisseur du dépôt de nitrure (X,Al)N réalisé est comprise entre 3 et 10 µm , et de préférence entre 4 et 6 µm.

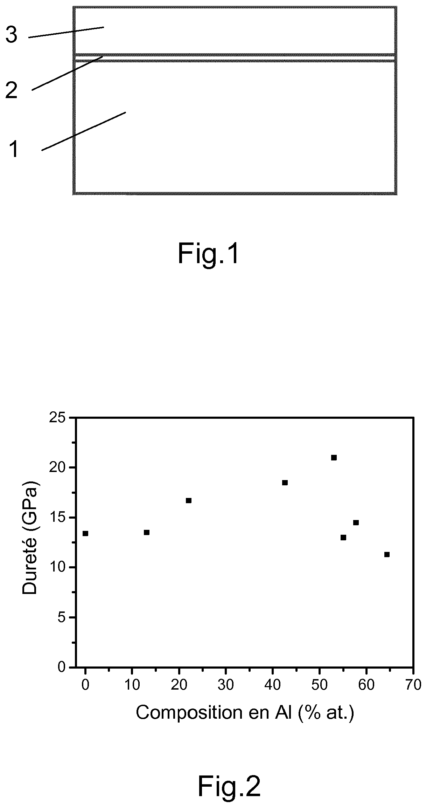

Si désiré une couche de dépôt métallique ou d'oxyde de l'un ou de plusieurs des constituants peut être réalisée avant la phase de nitruration, pour former une couche d'accroché 2 entre le substrat 1 et la couche de nitrure 3, tel que représenté sur la figure 1.

Les tests comparatifs de résistance à la rayure ont été menés avec les surfaces de cuisson suivantes : acier inoxydable (fini recuit brillant, avec une rugosité Ra de l'ordre de 0,1 µm), revêtements NbN, ZrNbN (60% Nb et 40% Zr, ou stoechiométrique), (Nb,Al)N avec différents pourcentages atomiques d'aluminium par rapport au total des éléments métalliques, ici 2% ; 13% ; 22%; 43% ; 53% et 70% d'Al.

La résistance à la rayure est évaluée avec un tampon abrasif de type Scotch Brite ® vert (chargé avec des particules d'alumine).

Pour obtenir un revêtement résistant totalement à la rayure selon le test précité, il est nécessaire d'avoir un revêtement présentant une dureté importante ainsi qu'une épaisseur minimale de revêtement de 4µm.

Les revêtements NbN et ZrNbN présentent une dureté suffisante pour obtenir une surface non rayable au Scotch Brite ® vert. En revanche, l'AlN possède une dureté plus faible ne permettant pas la résistance à la rayure.

La figure 2 illustre l'évolution de la dureté du revêtement en fonction du taux d'aluminium (de 0 à 65% d'Al). Ces mesures montrent que comparativement, dans la plage de taux d'aluminium 0→53%Al, l'ajout d'aluminium permet une augmentation de la dureté du dépôt. Ces essais montrent que la dureté des revêtements (Nb,Al)N est suffisante pour garantir une bonne résistance à la rayure et est même supérieure à celle NbN). De plus il a été validé qu'un revêtement (Nb,Al)N à 70% d'Al d'épaisseur 4µm permettait d'obtenir un revêtement résistant totalement à la rayure au tampon abrasif de type Scotch Brite ® vert. Dans ces cas-là, des mesures DRX ont montré que tous ces dépôts possédaient la structure cubique faces centrées du NbN, l'aluminium étant en substitution dans la maille NbN. L'augmentation de la dureté des revêtements avec la concentration en aluminium s'explique par un effet de durcissement en solution solide. Au-delà d'un taux critique en aluminium, la formation possible d'une phase amorphe riche en aluminium peut expliquer la diminution de la dureté des revêtements observée avant le passage à la structure cristallographique hexagonale de l'AlN.

Le tachage du revêtement NbN au cours de la cuisson est majoritairement généré par un phénomène d'oxydation conduisant à une couche interférentielle d'oxyde. Ainsi, une très faible variation d'épaisseur d'oxyde en surface du revêtement NbN (de l'ordre de 10 à 20 nm) peut causer une modification de la couleur perçue du revêtement par un observateur, du fait d'un phénomène de coloration interférentielle. Dans les zones tachées, une épaisseur d'oxyde plus importante que dans les zones non tachées a en effet été mesurée.

L'utilisation d'un revêtement présentant une cinétique d'oxydation très faible à la température de cuisson est en mesure de réduire, voire de supprimer le tachage. L'excellente résistance à l'oxydation du nitrure d'aluminium jusqu'à 600°C est en mesure d'assurer cette fonction antitache du revêtement. Ainsi, une poêle avec revêtement AlN a été élaborée et aucune tache n'a été observée après test de cuisson, grâce à son excellente résistance à l'oxydation. Toutefois, la faible dureté du revêtement AlN ne permet pas son utilisation tel quel (le revêtement AlN ne permet pas la résistance à la rayure au Scotch Brite ® vert). Toutefois, l'ajout d'aluminium dans un revêtement NbN présentant de bonnes propriétés de dureté peut permettre d'obtenir un revêtement combinant la forte dureté du revêtement amenée par NbN et la bonne résistance à l'oxydation amenée par AlN. L'objectif est d'avoir un revêtement suffisamment résistant à l'oxydation pour ne pas tacher à température d'utilisation d'une poêle (jusqu'à 350°C en cas de chauffe à vide à feu vif).

Les tests menés pour évaluer le tachage ont suivi le protocole suivant :
- 5 min de préchauffe du revêtement à 350°C,
- Dépôt d'une goutte d'un mélange tachant, par exemple 90% d'acide oléique, 9,9% de vitamine E, 0,1% de carotène,
- Chauffe pendant 5 min à 350°C sous air,
- Nettoyage manuel du résidu carbonisé, pour laisser apparaitre la surface de cuisson,
- Estimation visuelle du tachage.

Les échantillons (Nb,Al)N testés comportent les proportions atomiques d'aluminium suivantes : 0% (NbN) ; 2% ; 13% ; 22% ; 43% ; 53% ; 59% ; 75% d'Al ; 100% (AlN). Les échantillons tachés sont le NbN, et les (Nb,Al)N avec 2% et 13% d'Al. Par contre les échantillons (Nb,Al)N avec 22% ; 43% ; 53% ; 59% ; 75% d'Al ainsi que l'AlN sont non tachés. D'après ces résultats, un pourcentage atomique d'aluminium minimum de l'ordre de 20% (parmi les éléments métalliques du revêtement) est considéré comme nécessaire pour garantir le non tachage du revêtement au cours de la cuisson.

Les essais de facilité de nettoyage ont été effectués selon le protocole suivant : la surface à caractériser est recouverte d'un mélange de composé alimentaire présentant de fortes propriétés d'adhésion après carbonisation. Le mélange carbonisé est alors soumis à l'action d'un tampon abrasif.

Le mélange de composé alimentaire est par exemple le suivant : 34 mg/mL de glucose, 14,5 mg/mL d'amylopectine, 39 mg/mL d'ovalbumine, 13,5 mg/mL de caséine, 32,8 mg/mL d'acide linoléique. Après une cuisson au four pendant 20 min à 210°C et un refroidissement pendant 2 min, l'échantillon est immergé dans un mélange eau et de détergent pendant 5 min, puis nettoyé au plynomètre (appareil à abraser les résidus de cuisson). Le pourcentage de surface restant recouvert par du résidu de cuisson permet d'évaluer la facilité de nettoyage de la surface de cuisson.

Le tableau ci-dessous montre la facilité de nettoyage pour différents types de surface de cuisson : l'acier inoxydable, le ZrNbN (avec 66,6% de Zr pour 33,3% de Nb), ainsi que des (Nb,Al)N pour les pourcentages atomiques d'Al suivants : 0% (NbN) ; 2% ; 12% ; 22%; 41%; 53%; 59%; 76%; 100% (AIN) ; les essais ont été réalisés sur des surfaces maximales de 2 cm².

| **Matériau de la surface de cuisson** | **% de la surface restant recouvert par le résidu de cuisson après nettoyage** | **Ecart-type** |
|---|---|---|
| **inox** | 80 | 10 |
| **ZrNbN** | 31,5 | 20 |
| **NbN** | 91 | 5 |
| **NbAlN 2% Al** | 92,9 | 5 |
| **NbAlN 12% Al** | 82,9 | 15 |
| **NbAlN 22% Al** | 62,2 | 20 |
| **NbAlN 41% Al** | 78,45 | 5 |
| **NbAlN 53% Al** | 36,05 | 40 |
| **NbAlN 59% Al** | 37,85 | 20 |
| **NbAlN 76% Al** | 13,1 | 10 |
| **AlN** | 0 | 0 |

Il apparait que l'obtention d'une facilité de nettoyage satisfaisante nécessite une proportion d'Al plus importante que l'obtention d'une résistance au tachage satisfaisante. En effet la facilité de nettoyage est notablement améliorée par rapport à l'acier inoxydable pour les échantillons comportant 53% et 59% d'Al, et très notablement améliorée pour les échantillons comportant 76% d'Al.

Ainsi une surface de cuisson en (Nb,Al)N avec au moins 20% d'Al permet d'obtenir une résistance au tachage bien supérieure qu'avec une surface de cuisson en acier inoxydable, en NbN ou en ZrNbN.

Une surface de cuisson en (Nb,Al)N avec une proportion atomique d'aluminium supérieure ou égale à 40% permet de plus d'obtenir une facilité de nettoyage meilleure qu'avec une surface de cuisson en acier inoxydable, et meilleure que celle du ZrNbN, tout en présentant une très bonne résistance au tachage. L'ajout d'aluminium permet d'améliorer la facilité de nettoyage de façon importante par rapport à un revêtement NbN. Plus le taux d'aluminium est important, plus l'amélioration de la facilité de nettoyage est marquée.

Une surface de cuisson en (Nb,Al)N avec une proportion atomique d'aluminium supérieure ou égale à 65% permet de plus d'obtenir une facilité de nettoyage remarquable, notamment meilleure que celle du ZrNbN. Toutefois, une surface de cuisson en (Nb,Al)N avec une proportion atomique d'aluminium comprise entre 40% et 60% permet d'obtenir une bonne résistance aux passages en lave-vaisselle.

On note également que la couleur du revêtement formant la surface de cuisson est modifiée selon la teneur en aluminium du revêtement. Un revêtement NbN possède une couleur légèrement plus foncée que l'acier inoxydable. Avec des teneurs croissantes en aluminium, le dépôt NbAlN devient de plus en plus foncé. A 75% d'Al, le revêtement est anthracite.

La surface de cuisson selon l'invention permet de manière surprenante de concilier les avantages du NbN (forte dureté procurant une bonne résistance à la rayure, résistance aux agents lessiviels tels que ceux utilisés dans les lave-vaisselle) avec les avantages de l'AlN (très bonne résistance à l'oxydation procurant une très bonne résistance au tachage, facilité de nettoyage, limitation de l'adhésion des aliments lors de la cuisson), sans leurs inconvénients respectifs (faible dureté et mauvaise résistance aux agents lessiviels tels que ceux utilisés dans les lave-vaisselle pour l'AlN, faible résistance à l'oxydation favorisant le tachage, difficulté de nettoyage, et adhésion de certains aliments pendant la cuisson pour le NbN.

Ainsi un revêtement (Nb,Al)N avec une proportion atomique d'aluminium parmi les éléments métalliques comprise entre 20% et 75% présente des propriétés intéressantes de résistance au tachage, de résistance à la rayure, du fait d'une dureté élevée (de l'ordre de 15 GPa, supérieure à celle du NbN), ainsi que de résistance aux agents lessiviels utilisés dans les lave-vaisselle. De plus des proportions élevées d'aluminium favorisent la facilité de nettoyage.

Le second exemple de mise en oeuvre de la présente invention concerne le dépôt d'un revêtement de ZrN et l'influence d'un ajout d'aluminum. La surface de cuisson consiste ainsi en un dépôt de (Zr,Al)N.

Un essai de revêtement de (Zr,Al)N par pulvérisation cathodique magnétron a été effetué sur un article culinaire de type poêle, pour un pourcentage atomique d'aluminium compris entre 30% et 70%. Cet essai a permis de valider la résistance au tachage et à la rayure d'un tel revêtement.

Tout comme pour le niobium, la première étape a consisté à déterminer les meilleures conditions de dépôt de ZrN, avant l'élaboration de composés (Zr,Al)N.

Le revêtement de ZrN seul est un revêtement présentant une bonne facilité de nettoyage, et l'ajout d'aluminum augmente cette propriété.

Les taches, déjà moins présentes sur les revêtements ZrN que sur les revêtements NbN, disparaissent lors du dopage des revêtements par de l'aluminum.

De la même façon que pour le nitrure de niobium, l'aluminium peut permettre d'améliorer certaines propriétés des nitrures de métaux de transition X des colonnes 4, 5 et 6 du tableau de Mendeleiev (par exemple : Zr, Ti, Cr), à savoir :
- une meilleure résistance à l'oxydation, donc au tachage d'un revêtement (X,Al)N que celle d'un revêtement XN, pour un pourcentage atomique d'Al au moins égal à 20%,
- une dureté plus élevée, donc une résistance à la rayure supérieure, tant que le pourcentage atomique d'Al permet de conserver une structure cristallographique du type de celle du revêtement XN, et non du type de celle du revêtement AlN.

La présente invention porte ainsi sur une surface de cuisson d'aliments pour article culinaire ou appareil électroménager de cuisson, consistant en un dépôt de nitrure d'éléments métalliques sur un substrat, les éléments métalliques du dépôt comprenant un métal de transition X et l'aluminium, l'élaboration dudit dépôt comportant une étape de nitruration pour obtenir un revêtement de type (X,Al)N.

Plus particulièrement selon l'invention, le revêtement de type (X,Al)N est un nitrure du métal de transition X enrichi en aluminium, et non un nitrure d'aluminium enrichi en métal de transition X. De plus la proportion atomique d'aluminium dans les éléments métalliques dudit dépôt est au moins égale à 20%.

Dans les exemples de réalisation cités, le métal de transition X est choisi parmi le niobium ou le zirconium.

A titre de variante, le métal de transition pourrait être choisi parmi d'autres éléments des colonnes IV, V et VI du tableau de Mendeleiev, pour réaliser des revêtements d'autres nitrures de métaux de transition dopés par de l'aluminium, à l'exclusion du (Ti,Al)N ou du (Cr,Al)N. Des essais ont en effet montré que les performances de nettoyage de certaines taches du (Ti,Al)N ou du (Cr,Al)N étaient notoirement insuffisantes, l'utilisation d'acides forts étant nécessaire pour les éliminer.

A titre de variante, la présente invention porte également sur l'élaboration de revêtements qui ne sont pas uniquement à base de nitrure d'un seul métal de transition X enrichi en aluminium, mais à base de nitrure comportant plusieurs métaux de transition, notamment Nb et/ou Zr et/ou Ti et/ou Cr, combinés à de l'aluminium, dans lequel le niobium et/ou le zirconium est/sont majoritaire(s) parmi le ou les métaux de transition X, dans le but d'augmenter la dureté et/ou de modifier la couleur du revêtement.

La présente invention concerne également un article culinaire destiné à la cuisson d'aliments, comportant une surface de cuisson du type précité.

La présente invention concerne également un appareil électroménager destiné à la cuisson d'aliments, comportant une surface de cuisson et des moyens de chauffe électrique ou à gaz de ladite surface de cuisson, comportant une surface de cuisson du type précité.

La présente invention n'est nullement limitée aux exemples de réalisation décrits, mais englobe de nombreuses modifications dans le cadre des revendications.

## Revendications

1. Surface de cuisson d'aliments pour article culinaire ou appareil électroménager de cuisson, consistant en un dépôt de nitrure d'éléments métalliques sur un substrat, les éléments métalliques du dépôt comprenant un ou plusieurs métaux de transition X et l'aluminium, l'élaboration dudit dépôt comportant une étape de nitruration pour obtenir un revêtement de type (X,Al)N, **caractérisée en ce que** le revêtement de type (X,Al)N est un revêtement de nitrure(s) du ou des métaux de transition X enrichi(s) en aluminium, dans lequel le niobium et/ou le zirconium est/sont majoritaire(s) parmi le ou les métaux de transition X, et **en ce que** la proportion atomique d'aluminium dans les éléments métalliques dudit dépôt est au moins égale à 20%.

2. Surface de cuisson selon la revendication 1, **caractérisé en ce que** le ou les métaux de transition X est/sont choisis parmi le niobium et/ou le zirconium.

3. Surface de cuisson selon l'une des revendications 1 ou 2, **caractérisé en ce que** la proportion atomique d'aluminium dans les éléments métalliques dudit dépôt est comprise entre 20% et 75%.

4. Surface de cuisson selon l'une des revendications 1 à 3, **caractérisé en ce que** la proportion atomique d'aluminium dans les éléments métalliques dudit dépôt est comprise entre 40% et 75%.

5. Surface de cuisson selon l'une des revendications 1 à 4, **caractérisé en ce que** la proportion atomique d'aluminium dans les éléments métalliques dudit dépôt est comprise entre 40% et 60%.

6. Surface de cuisson selon l'une des revendications 1 à 5, **caractérisée en ce que** le dépôt est réalisé par dépôt physique en phase vapeur.

7. Surface de cuisson selon la revendication 6, **caractérisée en ce que** le dépôt est réalisé à partir d'une ou plusieurs cibles obtenues par assemblage sur un support conducteur d'une ou plusieurs tôle(s) ou plaque(s) de matériau ayant la composition recherchée, lesdites tôles ou plaques étant obtenues soit par laminage, soit par frittage de poudre ou projection thermique de poudre, soit issues de coulée.

8. Surface de cuisson selon l'une des revendications 6 ou 7, **caractérisée en ce que** le dépôt est réalisé en condition réactive afin d'accomplir, pendant l'étape de dépôt, l'étape de nitruration.

9. Surface de cuisson selon l'une des revendications 1 à 8, **caractérisée en ce que** l'épaisseur du dépôt de nitrure (X,Al)N réalisé est comprise entre 3 et 10 µm , et de préférence entre 4 et 6 µm.

10. Surface de cuisson selon l'une des revendications 1 à 9 **caractérisée en ce qu'**une couche de dépôt métallique de l'un ou plusieurs des constituants est réalisée avant la phase de nitruration.

11. Surface de cuisson selon l'une des revendications 1 à 10, **caractérisée en ce que** le substrat est composé d'une ou plusieurs tôle(s) métallique(s) des matériaux suivants : aluminium, cuivre, fonte, acier, notamment acier inoxydable.

12. Article culinaire destiné à la cuisson d'aliments, **caractérisé en ce qu'**il comporte une surface de cuisson selon l'une des revendications 1 à 11.

13. Appareil électroménager destiné à la cuisson d'aliments, comportant une surface de cuisson et des moyens de chauffe électrique ou à gaz de ladite surface de cuisson, **caractérisé en ce que** ladite surface de cuisson est conforme à l'une des revendications 1 à 12.

## Patentansprüche

1. Fläche zum Kochen von Lebensmitteln für einen Kochartikel oder elektrisches Kochgerät, das aus einer Nitridabscheidung von Metallelementen auf einem Substrat besteht, wobei die Metallelemente der Abscheidung ein oder mehrere Übergangsmetalle X und Aluminium umfassen, wobei die Bearbeitung von dieser Abscheidung einen Nitrierschritt umfasst, um eine Beschichtung vom Typ (X, Al)N zu erhalten, **dadurch gekennzeichnet, dass** die Beschichtung vom Typ (X, Al)N eine Beschichtung mit Nitrid(en) oder Übergangsmetallen X ist, das / die mit Aluminium angereichert ist / sind, wobei in dieser Niob und/oder Zirkonium unter den Übergangsmetallen X überwiegend ist / sind, und dass der Atomanteil von Aluminium in den Metallelementen der Abscheidung mindestens gleich 20% beträgt.

2. Fläche zum Kochen nach Anspruch 1, **dadurch gekennzeichnet, dass** das oder die Übergangsmetalle X aus Niob und / oder Zirkonium ausgewählt ist / sind.

3. Fläche zum Kochen nach einem der Ansprüche 1 oder 2, **dadurch gekennzeichnet, dass** der atomare Anteil von Aluminium in den Metallelementen der Abscheidung zwischen 20 % und 75 % beträgt.

4. Fläche zum Kochen nach einem der Ansprüche 1 bis 3, **dadurch gekennzeichnet, dass** der Atomanteil von Aluminium in den Metallelementen der Abscheidung zwischen 40 % und 75 % beträgt.

5. Fläche zum Kochen nach einem der Ansprüche 1 bis 4, **dadurch gekennzeichnet, dass** der Atomanteil von Aluminium in den Metallelementen der Abscheidung zwischen 40 % und 60 % beträgt.

6. Fläche zum Kochen nach einem der Ansprüche 1 bis 5, **dadurch gekennzeichnet, dass** die Abscheidung durch physikalische Gasphasenabscheidung erfolgt.

7. Fläche zum Kochen nach Anspruch 6, **dadurch gekennzeichnet, dass** die Abscheidung aus einem oder mehreren Zielgruppen hergestellt ist, die durch Zusammenfügen auf einem leitfähigen Träger eines oder mehrerer Bleche oder Platten aus einem Material erhalten wurden, das die gesuchte Zusammensetzung hat, wobei die Bleche oder Platten entweder durch Walzen oder durch Sintern von Pulver oder durch thermisches Spritzen von Pulver erhalten werden, oder vom Gießen stammen.

8. Fläche zum Kochen nach einem der Ansprüche 6 oder 7, **dadurch gekennzeichnet, dass** die Abscheidung in einem reaktiven Zustand erfolgt, um während des Abscheidungsschrittes den Nitrierschritt zu bewerkstelligen.

9. Fläche zum Kochen nach einem der Ansprüche 1 bis 8, **dadurch gekennzeichnet, dass** die Dicke der erzeugten Nitridabscheidung (X, Al)N zwischen 3 und 10 µm und vorzugsweise zwischen 4 und 6 µm beträgt.

10. Fläche zum Kochen nach einem der Ansprüche 1 bis 9, **dadurch gekennzeichnet, dass** eine Metallabscheidungsschicht aus einem oder mehreren der Bestandteile vor der Nitrierphase realisiert wird.

11. Fläche zum Kochen nach einem der Ansprüche 1 bis 10, **dadurch gekennzeichnet, dass** das Substrat aus einem oder mehreren Metallblechen der folgenden Materialien besteht: Aluminium, Kupfer, Gusseisen, Stahl, insbesondere Edelstahl.

12. Kochartikel, der zum Kochen von Nahrungsmitteln bestimmt ist, **dadurch gekennzeichnet, dass** er eine Fläche zum Kochen nach einem der Ansprüche 1 bis 11 aufweist.

13. Elektrisches Haushaltsgerät, das zum Kochen von Nahrungsmitteln bestimmt ist, aufweisend eine Fläche zum Kochen und elektrische Heizmittel oder Gasheizmittel der Fläche zum Kochen, **dadurch gekennzeichnet, dass** die Fläche zum Kochen gemäß einem der Ansprüche 1 bis 12 ist.

## Claims

1. Food cooking surface for a cookware item or an electrical household cooking appliance, consisting of a deposit of nitride of metal elements on a substrate, the metal elements of the deposit comprising one or more X transition metal(s) and aluminium, the production of said deposit comprising a nitridation step for obtaining a coating of the (X,AI)N type, **characterised in that** the (X,A1)N-type coating is a coating of nitride(s) of the one or more X transition metal(s), enriched with aluminium, in which niobium and/or zirconium make(s) up the majority of the one or more X transition metal(s), and **in that** the atomic ratio of aluminium in the metal elements of said deposit is at least equal to 20%.

2. Cooking surface as in claim 1, **characterised in that** one or more X transition metal(s) is/are chosen from niobium and/or zirconium.

3. Cooking surface according to one of claims 1 or 2, **characterised in that** the atomic ratio of aluminium in the metal elements of said deposit is between 20% and 75%.

4. Cooking surface according to one of claims 1 to 3, **characterised in that** the atomic ratio of aluminium in the metal elements of said deposit is between 40% and 75%.

5. Cooking surface according to one of claims 1 to 4, **characterised in that** the atomic ratio of aluminium in the metal elements of said deposit is between 40% and 60%.

6. Cooking surface according to one of claims 1 to 5, **characterised in that** the deposit is produced by physical vapour deposition.

7. Cooking surface according to claim 6, **characterised in that** the deposit is produced from one or several targets obtained by assembling one or several sheets or plates of material having the desired composition on a conductive support, said sheets or plates being obtained by lamination, powder sintering, thermal spraying of powder, or casting.

8. Cooking surface according to one of claims 6 or 7, **characterised in that** the deposit is produced under reactive conditions in order to carry out the nitridation step during the deposition step.

9. Cooking surface according to one of claims 1 to 8, **characterised in that** the (X,AI)N nitride deposit produced is between 3 and 10µm in thickness, preferably between 4 and 6µm.

10. Cooking surface according to one of claims 1 to 9, **characterised in that** a metal deposit layer of one or several of the constituents is produced before the nitridation phase.

11. Cooking surface according to one of claims 1 to 10, **characterised in that** the substrate is composed of one or several metal sheets of the following materials: aluminium, copper, cast iron, steel, particularly stainless steel.

12. Cookware item intended for cooking food, **characterised in that** the cookware comprises a cooking surface according to one of claims 1 to 11.

13. Electrical household appliance intended for cooking food, comprising a cooking surface and electrically- or gas-operated means for heating said cooking surface, **characterised in that** said cooking surface complies with one of claims 1 to 12.
